# EUROPÄISCHE PATENTANMELDUNG

(11) **EP 2 720 326 A1**
(43) Veröffentlichungstag der Anmeldung: **16.04.2014**
(21) Anmeldenummer: 13401024.8
(22) Anmeldetag: 12.03.2013
(51) Int. Cl.: H01S 5/00, H01S 5/022, H01S 5/026, G01N 21/35

(54) **Gasdetektions-Laserlichtquelle mit reduzierter optischer Rückkopplung**

(71) Anmelder: Axetris AG, 6056 Kägiswil (CH)
(72) Erfinder: Fraschina, Corrado, 6005 Luzern (CH); Wittmann, Andreas, 6074 Giswil (CH); Vogler, Daniel, 6005 Luzern (CH); Raab, Christoph, 6005 Luzern (CH)
(74) Vertreter: Klocke, Peter

(57) **Zusammenfassung**

Gasdetektions-Laserlichtquelle (1), mit einem Laserlicht emittierenden Halbleiterlaserchip (2), in dem ein sich aufweitender Laserstrahl (6) aus einer Laserapertur (5) austritt, und mit einer nahe der Laserapertur (5) angeordneten kollimierenden GRIN-Linse (7) zur Strahlformung, wobei auf der GRIN-Linse (7) ein Verzögerungsplättchen (11) an einer Lichtaustrittsseite (9) angeordnet ist, das die Polarisationsebene von rückreflektierten Anteilen des Laserstrahls (6) um 90° gegenüber dem emittierten Laserstrahl (6) dreht, so dass optische Wechselwirkungen zwischen diesen ausgeschlossen sind. Die GRIN-Linse (7) ist an der die Laserapertur (5) aufweisenden Abstrahlseite (4) des Halbleiterlaserchip (2) und das Verzögerungsplättchen (11) an der Lichtaustrittsseite (9) der GRIN-Linse (7) vorzugsweise mit einem Index angepassten Haftmittel (10, 10') befestigt.

## Beschreibung

Die Erfindung betrifft eine Gasdetektions-Laserlichtquelle, mit einem linear polarisiertes Licht emittierenden Halbleiterlaserchip, der eine Abstrahlseite mit einer Laserapertur aufweist, aus der ein sich aufweitender Laserstrahl austritt, und mit einer nahe der Laserapertur angeordneten kollimierenden GRIN-Linse, die mit einer Lichteintrittsseite an der Abstrahlseite mit einem Haftmittel befestigt ist und dabei die Laserapertur vollständig übergreift, wobei das Haftmittel Infrarotlicht durchlässig ist und sich zumindest über die Laserapertur lückenlos erstreckt.

Im Bereich Sicherheit, Komfort und Umweltschutz besteht ein großer Bedarf an kostengünstigen, zuverlässigen und hoch empfindlichen Gassensoren. Bekannte Gassensoren weisen Gase häufig mittels Absorptionsspektroskopie nach. Bei dieser Technik wird beispielsweise ein Laserstrahl einer geeigneten Frequenz durch ein Gas oder Gasgemisch geleitet, das das Laserlicht zumindest teilweise absorbiert. Die Frequenz des Laserlichtes ist abhängig von dem zu detektierenden Gas und so gewählt, dass das Laserlicht mit den Gasteilchen möglichst stark wechselwirkt. Der Absorptionsgrad des Laserlichtes wird dabei als Indikator für die Gaskonzentration genutzt. Für die Gasdetektion eignen sich insbesondere spektral einmodig strahlende Laser.

Bei der Laserabsorptionsspektroskopie wird der von der Laserquelle ausgehende Laserstrahl nach dem Durchtritt durch ein Gas oder Gasgemisch mittels eines Detektorelements erfasst, in ein elektrisches Signal umgewandelt und einem Signalanalysator zur Auswertung zugeleitet. Ein solcher Signalanalysator kann jedoch nicht immer unterscheiden, ob eine Änderung des detektierten Signals aufgrund einer Absorption oder aufgrund von Schwankungen der Laserleistung herrührt. Schwankungen der Laserleistung können durch Self-mixing Effekte entstehen, die je nach Phasenlage und Amplitude zu einem sich ändernden Interferenzmuster auf dem Detektorsignal führen können. Nicht vom Signalanalysator zu eliminierende Interferenzmuster erhöhen den Messfehler und senken die Nachweisempfindlichkeit für das zu detektierende Gas deutlich.

Sich ändernde Interferenzmuster werden zum einen durch auf den Halbleiterlaserchip und auf die im Strahlengang angeordneten optischen Strahlformungs-und/oder Strahllenkungselemente einwirkende Temperatureinflüsse verursacht, die die Länge des optischen Pfades für das Laserlicht bis zum Detektorelement verändern. Des Weiteren können Rückreflexionen des Laserlichtes an Innenflächen des Gehäuses der Gasdetektions-Laserlichtquelle oder an Grenzflächen von in dem Gehäuse angeordneten strahlformenden oder strahllenkenden optischen Elementen derartige unerwünschte Interferenzmuster herbeiführen. Dabei beeinflussen insbesondere Rückreflexionen des Laserlichtes in die Laserapertur des Halbleiterlaserchips den von dem Halbleiterlaserchip ausgesandten Laserstrahl im Hinblick auf das Rauschen äußerst negativ.

Es ist bekannt, den Halbleiterlaserchip zur Stabilisierung der optischen Weglänge des Laserlichtes auf einer Temperatursenke anzuordnen und ein den Laserstrahl beeinflussendes Optikelement, beispielsweise eine kollimierende Linse, mit dem Halbleiterlaserchip wärmeleitend zu verbinden, damit die Linse gegenüber dem Halbleiterlaserchip einen definierten Temperaturzustand aufweist.

Diese Art der thermischen Kopplung ist beispielsweise aus der EP 2 320 215 A1 bekannt. Diese offenbart einen Halbleiterlaseraufbau, insbesondere zur Gasdetektion, mit einem Gehäuse mit elektrischen Anschlüssen, das einen Boden und vorzugsweise ein Austrittsfenster aufweist. In dem Gehäuse sind ein Halbleiterlaserchip und eine aktive Temperiereinrichtung für den Halbleiterlaserchip angeordnet. Zwischen dem Halbleiterlaserchip und dem Austrittsfenster des Gehäuses ist eine temperierte kollimierende GRIN-Linse angeordnet. Diese steht mit dem Halbleiterlaserchip in einem innigen physischen Kontakt und ist vorzugsweise mit der Laserapertur stoffschlüssig oder adhäsiv verbunden.

Der vorstehend beschriebene bekannte Halbleiterlaseraufbau, bei dem das Strahlformungselement in direktem physischem Kontakt mit der Laserapertur steht, lässt jedoch störende Rückreflexionen des Laserlichtes, ausgehend von dem Fenster oder den Wänden des Gehäuses in die Laserapertur des Halbleiterlaserchips weitgehend ohne Beeinflussung ungehindert zu. Dies führt zu unerwünschten Interferenzerscheinungen zwischen dem in die Laserapertur eintretenden rückreflektierten Laserlicht und dem aus der Laserkavität des Halbleiterlaserchips ausgekoppelten, durch die Laserapertur austretenden Laserlichts.

Aus der Physik ist es bekannt, dass die Art und Größe der Wechselwirkung von sich in einem gemeinsamen Medium in unterschiedlicher Richtung ausbreitenden Laserstrahlen von der Polarisationsart und der Polarisationsrichtung des Lichtes abhängig ist. Diese grundlegende Erkenntnis ist bei der in der internationalen Patentanmeldung WO 01/0 28 38 A1 offenbarten Vorrichtung zur Gasdetektion wirksam umgesetzt. Dazu lehrt dieser Stand der Technik ein Verzögerungsplättchen in den Strahlengang von rückreflektiertem Laserlicht einzubringen, das die Polarisationsrichtung des rückreflektierten Laserstrahls beeinflusst. Die Ausrichtung des Verzögerungsplättchens gegenüber der Ausbreitungsrichtung der Laserstrahlen und dessen Dicke ist dabei so gewählt, dass die Polarisationsebenen des jeweils linear polarisierten Laserlichts einen 90°-Winkel miteinander einschließen. Hierbei ist das Verzögerungsplättchen nach einer kollimierenden bikonvexen Linse mit konstantem Brechungsindex beabstandet zur Linse angeordnet.

Ausgehend von dem vorstehend beschriebenen Stand der Technik liegt der Erfindung die Aufgabe zu Grunde eine Möglichkeit vorzuschlagen, mit der die durch Self-Mixing induzierte Modulation der Ausgangsleistung einer Gasdetektions-Laserlichtquelle deutlich reduziert wird, um die Empfindlichkeit einer Gasdetektionsvorrichtung im Hinblick auf das optische Rauschen zu verbessern.

Diese Aufgabe wird erfindungsgemäß durch eine Gasdetektions-Laserlichtquelle mit den Merkmalen des Anspruchs 1 gelöst. Weitere vorteilhafte Ausgestaltungen sind den rückbezogenen Ansprüchen zu entnehmen.

Der Erfindung liegt die Idee zu Grunde, einer Wechselwirkung von emittiertem und rückreflektiertem Laserlicht in dem optischen Resonator und/oder im dem Bereich der Laserapertur des Halbleiterlaserchips vorzubeugen und/oder das rückreflektierte Laserlicht derart zu lenken, dass es die Laserapertur verfehlt und nicht in den optischen Resonator eintritt. Dazu wird einerseits auf die Polarisationsrichtung und andererseits auf die Ausbreitungsrichtung des rückreflektierten Laserlichts mittels eines Verzögerungsplättchens in Verbindung mit einer strahlformenden GRIN-Linse Einfluss genommen. Ziel ist es, die Polarisationsebene der Rückreflexionen derart zu verändern, d. h. zu drehen, dass sich diese in einem orthogonalen Winkel zu der Polarisationsebene des emittierten Laserstrahls erstreckt. Kerngedanke der Erfindung ist es, das Verzögerungsplättchen und die GRIN-Linse mit den oben beschriebenen Eigenschaften derart in den Strahlengang einzubringen und miteinander und der Laserapertur optisch zu koppeln, dass an den Grenzflächen im Strahlengang starke Unterschiede der Reflexionskoeffizienten vermieden werden.

Dabei kann das Verzögerungsplättchen prinzipiell an einer Lichteintrittsseite oder an einer Lichtaustrittsseite der GRIN-Linse mit einem Haftmittel befestigt sein, das die jeweilige Seite vollständig bedeckt. Als Lichteintrittsseite der GRIN-Linse wird die der Laserapertur zugewandte und als Lichtaustrittsseite die der Laserapertur abgewandte Seite der GRIN-Linse bezeichnet.

Es hat sich jedoch herausgestellt, dass die Anordnung des Verzögerungsplättchens zwischen der Lichteintrittsseite der GRIN-Linse und der Laserapertur des Halbleiterlaserchips nur effektiv bei der Anwendung auf achsennahe Strahlen ist. Für die Reduktion von Interferenzen innerhalb des Gehäuses der Gasdetektions-Laserlichtquelle ist diese Anordnung jedoch nicht sensitiv genug. Es wird vermutet, dass der von dem senkrechten Einfall abweichende Strahlungswinkel auf das Verzögerungsplättchen die Ursache für das relativ ineffiziente Verhalten dieser speziellen Anordnung ist. De facto ist es äußerst wichtig für eine optimale Drehung (d. h. um 90°), das Verzögerungsplättchen unter dem korrekten Winkel zu bestrahlen. Das kann in der Variante, bei der das Verzögerungsplättchen zwischen der GRIN-Linse und dem Halbleiterlaserchip angeordnet ist, nicht erreicht werden. Somit ergibt sich immer ein wirksamer Restanteil des elektromagnetischen Feldes des rückreflektierten Laserlichts, der in der Polarisationsebene des emittierten Laserstrahls liegt und der somit mit dem elektromagnetischen Feld im Halbleiterlaserchip interferieren kann, was zu einer Beeinflussung der Phase und der Amplitude des elektromagnetischen Feldes dort führt und damit unerwünschte Fluktuationen der Ausgangsleistung des austretenden Laserstrahls bewirkt.

Diese Fluktuationen können zu einer Steigerung der Rauschintensität und zu einer Verzerrung des detektierten Signals führen. Im ungünstigsten Fall bedingen diese Fluktuationen ein Störsignal an dem Detektor der Gasdetektionsvorrichtung, das fälschlicherweise als Gasabsorptionssignal interpretiert wird und damit zu einer reduzierten Performance-Sensitivität von Gassensoren führt. Die Ursache dieses Problems ist bei der vorstehend beschriebenen unvorteilhaften Anordnung des Verzögerungsplättchens darin begründet, dass das Laserlicht mit einer breiten Winkelverteilung auf das Verzögerungsplättchen auftrifft, was zu einer vom optimalen 90° Winkel abweichenden Drehung des elektromagnetischen Feldes, bei 2n-maligem Durchgang durch das Verzögerungsplättchen, führt und somit Anteile der Rückreflexionen bewirkt, die mit dem elektromagnetischen Feld im Halbleiterlaserchip interferieren können.

Aus diesem Grund schlägt die Erfindung eine verbesserte Variante vor, die sicherstellt, dass der Einfallswinkel des emittierten und zurückkommenden Laserstrahls bezüglich dem Verzögerungsplättchen eingeschränkt ist, indem der von der Laserapertur ausgehende Laserstrahl mittels der GRIN-Linse kollimiert wird, bevor er in das Verzögerungsplättchen einfällt. Dazu ist das Verzögerungsplättchen erfindungsgemäß auf der GRIN-Linse an der Lichtaustrittsseite angeordnet und deckt die Lichtaustrittsseite vollständig ab, wobei das Verzögerungsplättchen mit einem Haftmittel an der GRIN-Linse fixiert ist, das die Lichtaustrittsseite restlos bedeckt. Dabei ist die GRIN-Linse vorzugsweise so positioniert, dass die Laserapertur in ihrer Fokalebene liegt. Hierbei kann die GRIN-Linse eine Lichtaustrittsseite aufweisen, die sich parallel oder geneigt gegenüber der Lichteintrittsseite erstreckt. Die GRIN-Linse kollimiert das Laserlicht, so dass der Laserstrahl nach der GRIN-Linse mit einem kleineren Öffnungswinkel auf das Verzögerungsplättchen auftrifft.

Bei einer bevorzugten Ausführungsform der Erfindung ist das Verzögerungsplättchen derart im Strahlengang angeordnet, dass sich dessen optische Achse um 45° relativ zu dem elektromagnetischen Feld der austretenden Laserstrahlung erstreckt. Durch eine geeignete Dicke des Verzögerungsplättchens wird das einfallende Laserlicht beim Durchgang durch das Verzögerungsplättchen vorzugsweise zirkular polarisiert. Für rückreflektiertes oder rückgestreutes Laserlicht, das senkrecht auf das Verzögerungsplättchen fällt, wird das elektromagnetische Feld derart gedreht, dass dieses nach dem Durchgang durch das Verzögerungsplättchen um 90° relativ zur emittierten Laserstrahlung gedreht ist und somit Interferenzeffekte im Halbleiterlaserchip sicher verhindert werden.

In diesem Zusammenhang ist es zweckmäßig, wenn die Haftmittel die Reflexionskoeffizienten an den für die Rückreflexionen und/oder Beugungen bzw. Brechungen wirksamen Grenzflächen zwischen der GRIN-Linse und der Laserapertur und/oder der GRIN-Linse und dem Verzögerungsplättchen reduzieren, indem die Brechzahlunterschiede des mindestens einen Haftmittels durch geeignete Wahl des Brechungsindex gegenüber der GRIN-Linse und/oder dem Verzögerungsplättchen minimiert werden.

Bei einer begünstigten Ausführungsform der Erfindung weist das Haftmittel einen der jeweiligen GRIN-Linse zumindest annähernd gleichen Brechungsindex auf. Ein solches Haftmittel kann sowohl an der Lichteintrittsseite als auch an der Lichtaustrittsseite der GRIN-Linse verwendet werden. Alternativ kann an der Lichtaustrittsseite auch ein Haftmittel verwendet werden, dessen Brechungsindex zumindest annähernd dem des Verzögerungsplättchens entspricht. Idealerweise verwendet man ein Material für das Verzögerungsplättchen, das einen gleichen oder vom Material her möglich, einen möglichst ähnlichen Brechungsindex wie die GRIN-Linse aufweist.

Besonders einfach ist die GRIN-Linse an dem Halbleiterlaserchip zu befestigen, wenn das Haftmittel als planparallele Schicht zwischen der Austrittsseite des Halbleiterlaserchips und der Lichteintrittsseite der GRIN-Linse angeordnet wird. Dabei erstrecken sich die Austrittsseite des Halbleiterlaserchip und die Lichteintrittsseite nach der Montage parallel zueinander. Diese Variante hat allerdings den Nachteil, dass die planen Grenzflächen zwischen dem Halbleiterlaserchips und der GRIN-Linse bzw. dem Verzögerungsplättchen einen Fabry-Perot-Resonator bilden, was trotz eines Haftmittels mit angepasstem Brechungsindex zu Interferenzeffekten führen kann.

Das Verzögerungsplättchen ist nur für ungeradzahlige Vielfache von Reflexionen an der Grenzfläche Luft-Verzögerungsplättchen wirksam, da sich das elektromagnetische Feld nach geradzahligen Vielfachen von Reflexionen und nach Passieren des Verzögerungsplättchens wieder in der ursprünglichen Polarisationsrichtung befindet. Daher ist es von Vorteil, dafür zu sorgen, dass rückreflektierte Laserstrahlen nicht mehr direkt in die Laserapertur treffen. Dies kann erreicht werden, indem der aus dem Verzögerungsplättchen austretende Laserstrahl in einem Winkel abweichend von 90° zu der Oberfläche des Verzögerungsplättchens aus dem Verzögerungsplättchen austritt. Dies kann beispielsweise dadurch erreicht werden, indem eine GRIN Linse verwendet wird deren Lichtaustrittsseite sich in einem bestimmten, von null Grad abweichendem Winkel zu der Lichteintrittsseite erstreckt. Alternativ kann auch das Verzögerungsplättchen unter einem von null Grad abweichendem Winkel zur Austrittsseite aufgeklebt werden. Mit dieser Maßnahme lässt sich eine Rückkopplung von Laserlicht, welches an der Grenzfläche zwischen dem Verzögerungsplättchen und der Luft reflektiert wurde, zuverlässig vermeiden.

Dieselbe Wirkung kann erzielt werden, indem eine GRIN-Linse, mit sich parallel gegenüberliegender Lichteintritts- und Austrittsseite, gegenüber der Laserapertur seitlich verschoben wird, sodass die optische Achse der GRIN-Linse nicht mehr mit der Mittelachse der Laserapertur zusammenfällt. Der rückreflektierte Laserstrahl wird dann von der GRIN-Linse in einem Sammelpunkt fokussiert, der nicht mehr mit dem eigentlichen Fokuspunkt der GRIN-Linse zusammenfällt, sondern der seitlich gegenüber dem Mittelpunkt der Laserapertur soweit verschoben ist, dass der Sammelpunkt außerhalb der Laserapertur liegt. Je weiter die GRIN-Linse relativ zur Laserapertur verschoben wird, desto größer wird auch der Abstand zwischen der Laserapertur und einem auftreffenden rückreflektierten Laserstrahl.

Eine seitliche Verschiebung der GRIN-Linse führt allerdings dazu, dass der aus dem Verzögerungsplättchen austretende Laserstrahl nicht mehr senkrecht zu der Abstrahlseite des Halbleiterlaserchips verläuft, sondern einen Neigungswinkel zur Normalen zeigt. Durch eine Verkippung der GRIN Linse ist es möglich, den durch die Verschiebung der GRIN Linse erzeugten Neigungswinkel des ausgekoppelten Laserlichtes zu beeinflussen. Um das Laserlicht senkrecht zu der Abstrahlseite des Lasers aus dem Verzögerungsplättchen auszukoppeln, ergibt sich je nach Verschiebeposition der GRIN-Linse relativ zu der Laserapertur ein anderer Verkippungswinkel für die GRIN-Linse. Bei einem konkreten Beispiel für eine 1 mm lange GRIN-Linse mit 500 µm Durchmesser ergibt sich für einen Versatz von 50 µm zum Mittelpunkt der Laserapertur eine Verkippung von 3°. Dabei ist zu beachten, dass die Dicke des Verzögerungsplättchens bei nicht senkrechtem Einfall so zu wählen ist, dass dieses das elektrische Feld um 45° dreht. Alternativ kann auch anstatt einer Verkippung der Linse eine GRIN-Linse verwenden werden, deren Lichtaustrittsseite sich in einem bestimmten, von null Grad abweichenden Winkel zu der Lichteintrittsseite erstreckt oder das Verzögerungsplättchen unter einem bestimmten, von null Grad abweichenden Winkel auf die GRIN Linse geklebt werden.

Durch die vorstehend beschriebenen Maßnahmen trifft das Laserlicht, welches an einer der Grenzflächen zwischen der Laserapertur und der Luft reflektiert wurde, nicht mehr direkt in die Laserapertur. Dennoch kann noch reflektiertes Laserlicht, wenn auch mit stark verringerter Intensität, das nicht über das Verzögerungsplättchen in die GRIN-Linse eintritt, generell über Mehrfachreflexionen/- streuungen die Laserapertur erreichen. Dies kann verhindert werden, wenn die Abstrahlseite eine um die Laserapertur angeordnete Zone mit verminderter Reflexionsfähigkeit aufweist. Dazu kann die Oberfläche der Zone rau ausgebildet oder mit einem absorbierenden Material beschichtet sein.

Die vorstehend angegebenen Maßnahmen zur effizienten optischen Rückkopplungsunterdrückung eignen sich sowohl für oberflächenemittierende wie auch kantenemittierende Halbleiterlaserchips gleichermaßen. Während bei einem Oberflächenemitter rückreflektiertes Laserlicht, das durch die GRIN-Linse fällt, in jeden Fall auf die Abstrahlseite trifft, ist dies bei einem Kantenemitter nicht zwingend so. Verwendet man die vorstehend angegebenen Maßnahmen bei einem Kantenemitter, so kann die GRIN-Linse bei geeigneter Verkippung der optischen Achse der GRIN-Linse gegenüber der Mittelachse der Laserapertur und einem geeigneten seitlichen Versatz der optischen Achse gegenüber der Mittelachse rückreflektierte Laserstrahlen nicht nur von der Laserapertur fernhalten, sondern sogar von der Abstrahlseite weglenken, insbesondere daran vollkommen vorbeilenken.

Des weiteren kann auch eine Rückreflexion an der Grenzfläche zu Luft vermindert werden, in dem dort eine Entspiegelungsschicht aufgebracht wird.

In einem weiteren Schritt kann die Gasdetektions-Laserlichtquelle in Hinblick auf unerwünschte Interferenzmodulation nochmals verbessert werden. Eine Drehung des elektromagnetischen Feldes um 90° wird nur für einen bestimmten Einfallswinkel auf das Verzögerungsplättchen erreicht. Trifft rückreflektiertes Licht in einem davon abweichenden Winkel auf das Verzögerungsplättchen auf, so verbleibt ein Restanteil des elektromagnetischen Feldes in Richtung des elektromagnetischen Feldes innerhalb des Halbleiterlaserchips. Dieses Licht trifft zwar nicht direkt auf die Laserapertur, kann diese jedoch durch Mehrfachreflexionen erreichen. Eine weitere Verbesserung zielt auf eine Einschränkung der Apertur auf das Verzögerungsplättchen ab, d.h. der mögliche Einfallswinkel auf des Verzögerungsplättchen wird eingeschränkt. Dazu ist bei einer bevorzugten Ausführungsform der Erfindung auf dem Verzögerungsplättchen eine zweite GRIN-Linse angeordnet, die der ersten, der Laserapertur zugeordneten GRIN-Linse diametral oder seitlich versetzt spiegelbildlich gegenüberliegt und mit einem Haftmittel an dem Verzögerungsplättchen befestigt ist, das sich lückenlos zwischen der zweiten GRIN-Linse und dem Verzögerungsplättchen erstreckt und das für Laserlicht durchlässig ist. Mit diesem Aufbau wird erreicht, dass schräg einfallendes rückreflektiertes Licht mit der zweiten GRIN Linse kollimiert wird und somit das Verzögerungsplättchen mit reduziertem Einfallswinkel trifft. Zudem wird der hohe Sprung der Berechungsindexänderung zwischen dem Verzögerungsplättchen der Luft vermieden, der zu Interferenzeffekten führen kann. Bevorzugt wird dabei ein Haftmittel verwendet, das im Brechungsindex an das Verzögerungsplättchen und/oder an die zweite GRIN-Linse angepasst ist. Die Form und die optischen Eigenschaften der zweiten GRIN-Linse können dabei gegenüber der ersten GRIN-Linse gleich oder unterschiedlich sein.

Vorzugsweise wird eine zweite GRIN-Linse verwendet, die auf der Lichteintrittsseite nicht abgeschrägt ist. Somit lässt sich diese einfach mit dem Verzögerungsplättchen über eine dünne ebene Schicht aus einem geeigneten Haftmittel verbinden. Für eine einfach Montage der zweiten GRIN-Linse auf dem auf der ersten GRIN-Linse angeordneten Verzögerungsplättchen ist es günstig, eine erste GRIN-Linse zu verwenden, deren Lichteinstrittsseite und Lichtaustrittsseite parallel zueinander verlaufen und die erste GRIN-Linse ohne seitliche Verkippung an der Abstrahlseite die Laserapertur übergreifend zu befestigen. Die zweite GRIN-Linse kann eine zu ihrer optischen Achse senkrechte oder eine gegenüber dieser geneigte Lichtaustrittsseite aufweisen. Auch unterschiedliche Längen der beiden GRIN-Linsen sind miteinander kombinierbar.

Bei einer begünstigten Ausführungsform weist hierbei die zweite GRIN-Linse eine parallel zu der Lichteintrittsseite verlaufende Lichtaustrittsseite auf und vorzugsweise eine der ersten GRIN-Linse zumindest ähnliche Länge auf. Bei einer Weiterbildung dieser Variante trägt die zweite GRIN-Linse an ihrer Lichtaustrittseite eine konvergierende Linse, beispielsweise eine Kugellinse, die mit Haftmittel an der GRIN-Linse befestigt ist, das die Lichtaustrittsseite vollständig bedeckt und für Infrarotlicht durchlässig ist, wobei der Abstand zwischen der zweiten GRIN-Linse und der konvergierenden Linse derart gewählt ist, dass der Fokuspunkt der konvergierenden Linse in der Fokalebene der zweiten GRIN-Linse zu liegen kommt. Die zusätzliche Kugellinse hat ebenso wie eine zusätzliche andere kollimierende oder fokussierende bikonvexe Linse den Vorteil, dass zwischen der gekrümmten Oberfläche der Linse und den anderen planen Flächen im Allgemeinen kein Fabry-Perot-Resonator gebildet wird. Das Haftmittel, welches die konvergierende Linse mit der zweiten GRIN-Linse verbindet, ist ebenfalls Index angepasst ausgewählt. Als kollimierende oder fokussierende Linse kann statt der Kugellinse natürlich auch eine Halbkugellinse verwendet werden.

Prinzipiell kann anstelle einer zweiten GRIN-Linse mit einer an der Lichtaustrittsseite angeordneten kollimierenden oder fokussierenden Linse als weiteres Strahlformungselement, bei der die Linse auf der zweiten GRIN-Linse mit Haftmittel befestigt ist, eine zweite GRIN-Linse ohne zusätzliche Linse treten, wenn diese axial doppelt so lang wie die erste GRIN-Linse ausgebildet ist, d. h. wenn eine sogenannte Half-wave-GRIN-Linse verwendet wird. Diese ist vorzugsweise an der Lichtaustrittseite abgeschrägt, um direktes Feedback zu reduzieren. Diese kann noch durch eine Entspiegelung der Lichtaustrittsseite der zweiten GRIN-Linse unterstützt werden. Alternativ oder zusätzlich kann auch ein Polarisator innerhalb einer der vorstehend beschriebenen Mehrfachkomponenten-Optiken integriert werden, der dafür sorgt, dass das um 90° gedrehte Licht gar nicht mehr auf die Laserapertur fällt.

Bei allen vorstehend beschriebenen Ausführungsformen der Erfindung ist das Verzögerungsplättchen vorzugsweise als Lambda-Viertel-Plättchen, vorzugsweise als Quarz-Plättchen ausgebildet. Dabei ist die Dicke und/oder Orientierung des Verzögerungsplättchens zweckmäßigerweise derart gewählt, dass immer eine Drehung des elektromagnetischen Feldes des einfallenden Laserstrahles, nach zweimaligen Durchgang um 90° erfolgt. Der von der Laserapertur emittierte Laserstrahl ist jeweils nach dem Durchtritt durch das Verzögerungsplättchen zirkular polarisiert. Zirkular polarisierte Rückreflexionen, die das Verzögerungsplättchen in entgegengesetzter Richtung passieren, werden dabei linear polarisiert, wobei die Polarisationsebenen der Laserstrahlen, die sich von der Laserapertur weg bzw. zu dieser hin erstrecken, einen Winkel von 90° miteinander einschließen, so dass eine gegenseitige Beeinflussung ausgeschlossen ist.

Mittels der erfindungsgemäßen Gasdetektions-Laserlichtquelle können störende Rückkopplungen des von dem Halbleiterlaserchip erzeugten Laserstrahls deutlich reduziert werden. Durch das die Polarisationsrichtung von Rückreflexionen des Laserstrahls räumlich drehende Self-Mixing reduzierende Verzögerungsplättchen wird die Wechselwirkung des in die Laserapertur rückreflektierten Laserlichts mit dem zu emittierenden Laserlicht minimiert. Zudem wird durch die Befestigung des Verzögerungsplättchens an der GRIN-Linse und/oder optional der Befestigung einer weiteren GRIN-Linse mit oder ohne einer danach angeordneten fokussierenden oder kollimierenden Linse mit einem optischen Haftmittel mit gleichem Brechungsindex die Zahl der Reflexionsflächen in dem Strahlengang des Laserstrahls auf ein Minimum beschränkt. Für diese Maßnahmen muss für ein quarzbasierendes Verzögerungsplättchen nur wenig investiert werden, womit es möglich ist, eine sehr günstige Gasdetektions-Laserlichtquelle mit geringer Baugröße herzustellen.

Nachfolgend wird die Erfindung anhand von in der Zeichnung dargestellten Ausführungsbeispielen näher erläutert. Weitere Merkmale der Erfindung können sich aus der folgenden Beschreibung der Ausführungsbeispiele der Erfindung in Verbindung mit den Ansprüchen und der beigefügten Zeichnung ergeben. Die einzelnen Merkmale der Erfindung können dabei für sich allein oder zu mehreren bei unterschiedlichen Ausführungsformen der Erfindung verwirklicht sein. Es zeigen:

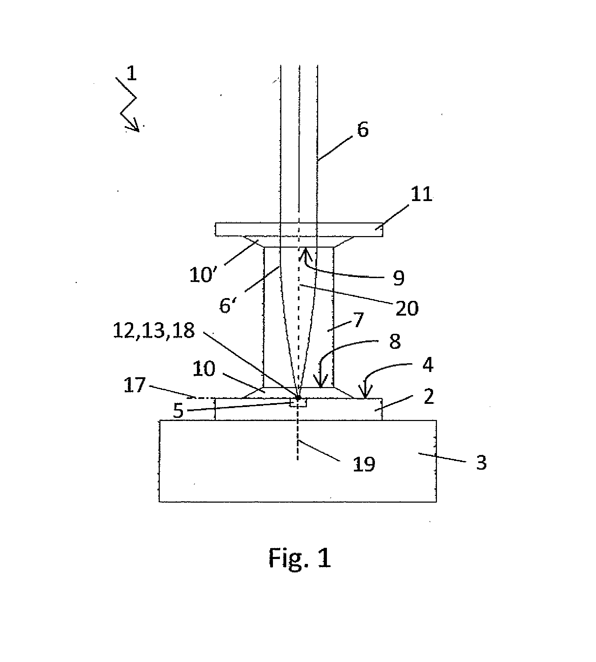

- Figur 1: eine erste Ausführungsform der erfindungsgemäßen Gasdetektions-Laserlichtquelle, mit einer GRIN-Linse und einem darauf angeordneten Verzögerungsplättchen, die eine parallel zur Lichteintrittsseite angeordnete Lichtaustrittsseite aufweist, wobei die GRIN-Linse konzentrisch und senkrecht zur Laserapertur angeordnet ist;

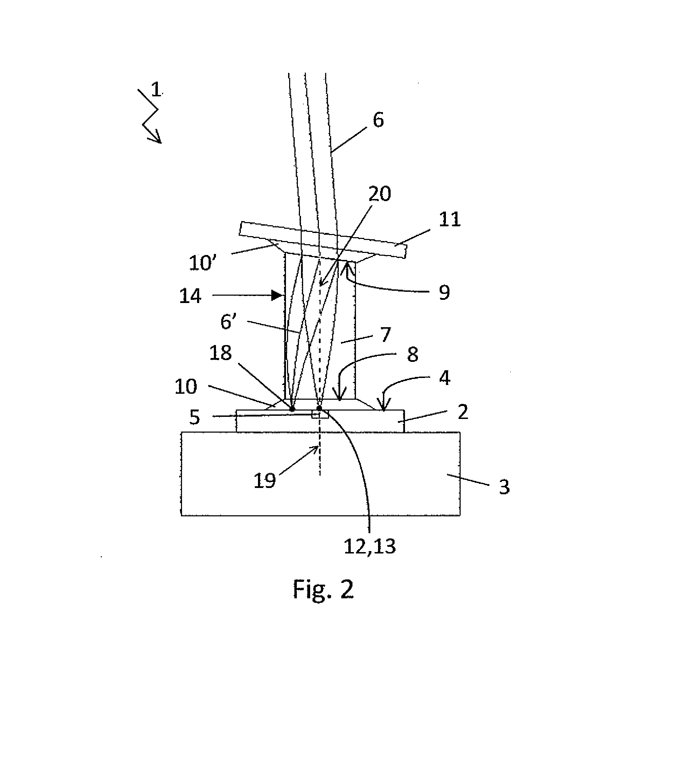

- Figur 2: eine zweite Ausführungsform der erfindungsgemäßen Gasdetektions-Laserlichtquelle, mit einer GRIN-Linse und einem darauf angeordneten Verzögerungsplättchen, die eine geneigt zur Lichteintrittsseite angeordnete Lichtaustrittsseite aufweist, wobei die GRIN-Linse konzentrisch und senkrecht zur Laserapertur angeordnet ist;

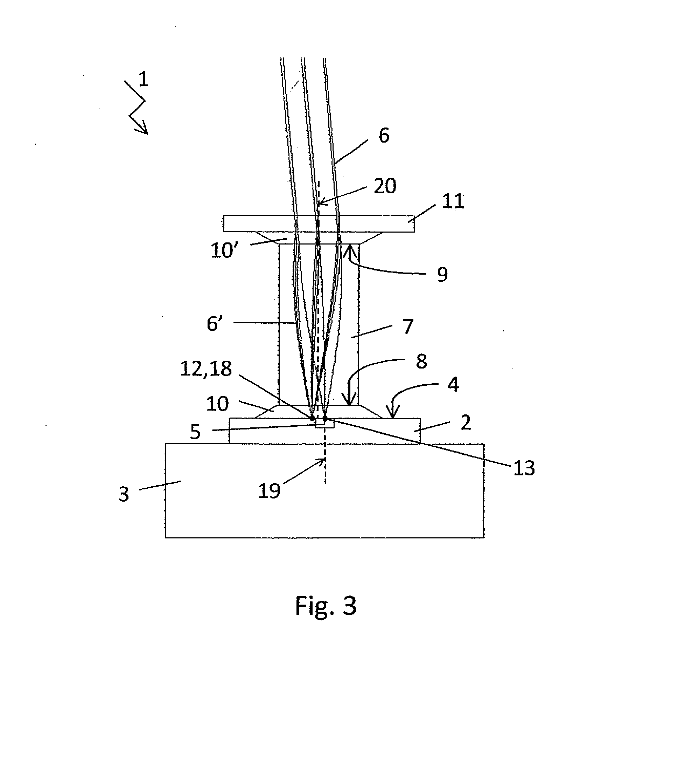

- Figur 3: eine dritte Ausführungsform der erfindungsgemäßen Gasdetektions-Laserlichtquelle, mit einem der Figur 1 entsprechenden Aufbau, bei der die GRIN-Linse seitlich gegenüber der Laserapertur verschoben ist;

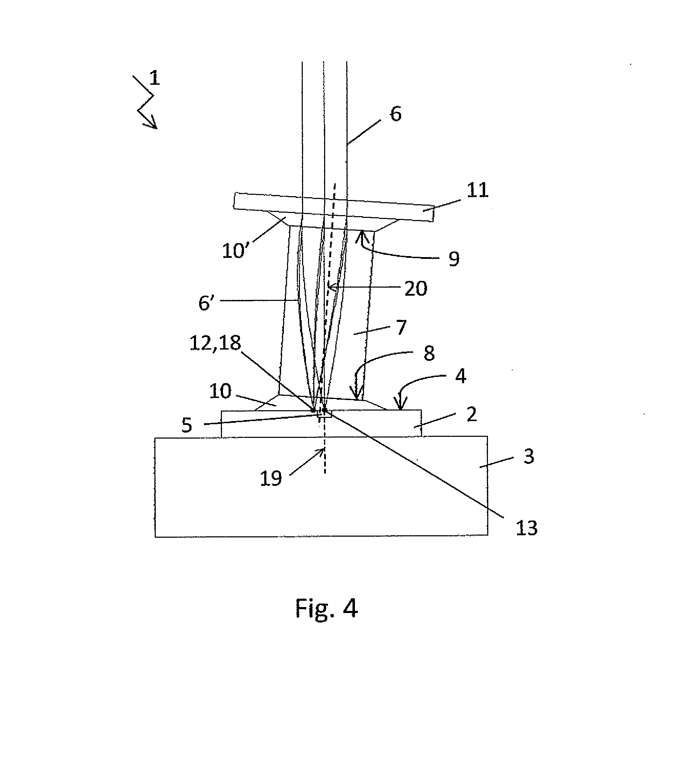

- Figur 4: eine vierte Ausführungsform der erfindungsgemäßen Gasdetektions-Laserlichtquelle, mit einer GRIN-Linse und einem darauf angeordneten Verzögerungsplättchen, die eine parallel zur Lichteintrittsseite angeordnete Lichtaustrittsseite aufweist, wobei die GRIN-Linse seitlich versetzt und seitlich verkippt zur Laserapertur angeordnet ist;

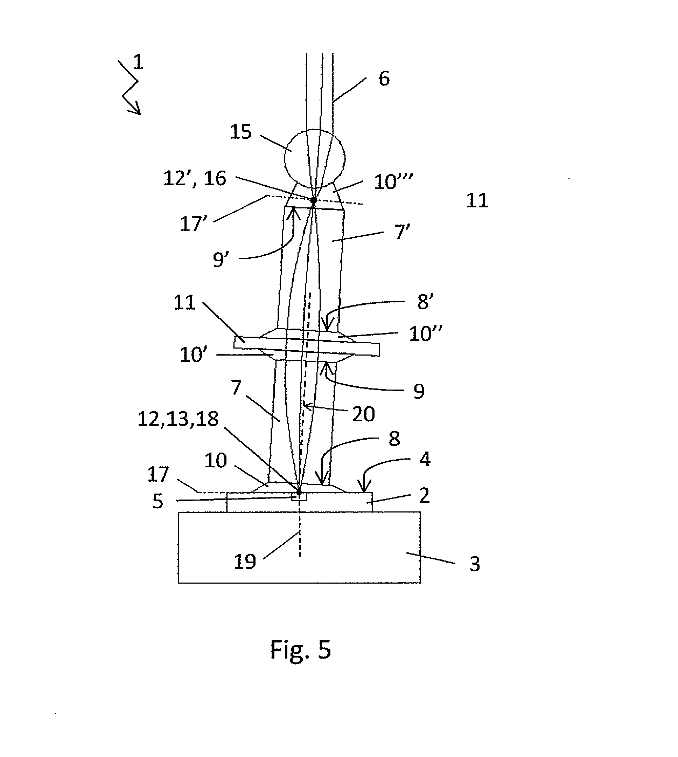

- Figur 5: eine fünfte Ausführungsform der erfindungsgemäßen Gasdetektions-Laserlichtquelle, mit einer ersten GRIN-Linse und einem darauf angeordneten Verzögerungsplättchen gemäß Figur 4 und mit einer von dem Verzögerungsplättchen getragenen zweiten GRIN-Linse, an der auf der Lichtaustrittsseite eine Kugellinse angeordnet ist; und

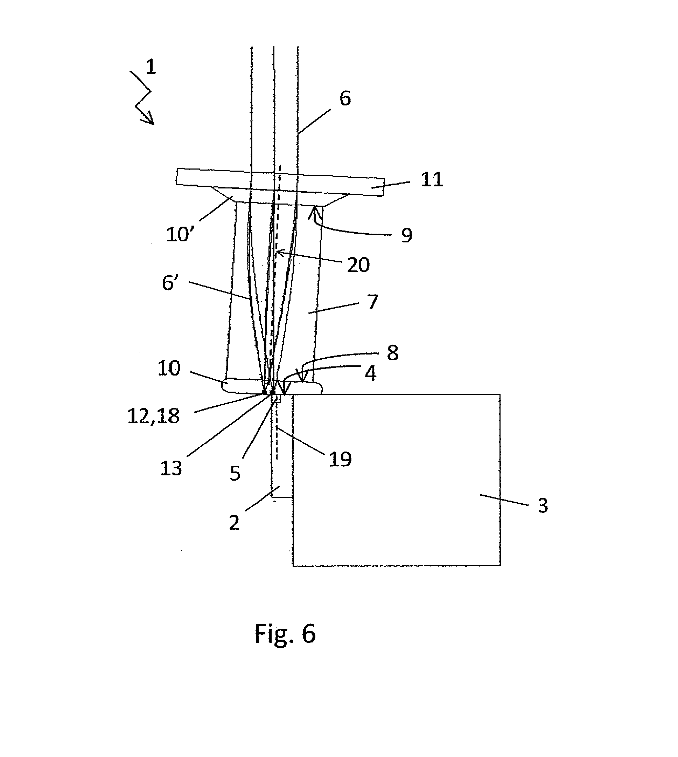

- Figur 6: eine sechste Ausführungsform der erfindungsgemäßen Gasdetektions-Laserlichtquelle, mit einer GRIN-Linse und einem darauf angeordneten Verzögerungsplättchen, die eine parallel zur Lichteintrittsseite angeordnete Lichtaustrittsseite aufweist, wobei die GRIN Linse seitlich versetzt und seitlich verkippt zur Laserapertur angeordnet ist und wobei der Halbleiterlaserchip anstelle eines Oberflächenemitters ein Kantenemitter ist.

Die Figur 1 zeigt eine erfindungsgemäße Gasdetektions-Laserlichtquelle 1, mit einem linear polarisiertes Infrarotlicht emittierenden Halbleiterlaserchip 2, der auf einem Unterbau 3, beispielsweise einem AIN-Substrat angeordnet ist. Der Unterbau 3 mit dem Halbleiterlaserchip 2 ist in einem in der Zeichnung nicht dargestellten Gehäuse der Gasdetektions-Laserlichtquelle 1 eingebaut, in dem sich auch eine Temperaturstabilisierungseinheit für den Halbleiterlaserchip 2 befindet. Der Halbleiterlaserchip 2 weist eine Abstrahlseite 4 mit einer Laserapertur 5 auf, aus der ein sich aufweitender Laserstrahl 6 austritt. An der Abstrahlseite 4 ist nahe der Laserapertur 5 eine kollimierende GRIN-Linse 7 angeordnet, die eine Lichteintrittsseite 8 und eine Lichtaustrittsseite 9 für den von der Laserapertur 5 ausgehenden Laserstrahl 6 aufweist. Die Lichteintrittsseite 8 und die Lichtaustrittsseite 9 erstrecken sich parallel zueinander. Die GRIN-Linse 7 ist mit der Lichteintrittsseite 8 an der Abstrahlseite 4 die Laserapertur 5 vollständig übergreifend mit einem Haftmittel 10 befestigt. Das Haftmittel 10 ist durchlässig für Infrarotlicht und erstreckt sich lückenlos über die Laserapertur 5 und ebenso über die Lichteintrittsseite 8. Damit ist ein direkter und inniger physischer Kontakt der gesamten Laserapertur 5 mit der größeren Lichteintrittsseite 8 der GRIN-Linse 7 hergestellt. Die runde Lichteintrittsseite 8 ist konzentrisch zu der Laserapertur 5 angeordnet, wobei sich die GRIN-Linse 7 senkrecht zu der Abstrahlseite 4 des Halbleiterlaserchips 2 aufrecht stehend ausdehnt.

Die GRIN-Linse 7 trägt auf der Lichtaustrittsseite 9 ein Verzögerungsplättchen 11, das die Lichtaustrittsseite 9 vollständig abdeckt, wobei das Verzögerungsplättchen 11 mit einem Haftmittel 10' an der GRIN-Linse 7 fixiert ist, das die Lichtaustrittsseite 9 restlos bedeckt. Die Haftmittel 10' erstreckt sich als dünne planparallele Schicht zwischen der GRIN-Linse 7 und dem Verzögerungsplättchen 11, das Haftmittel 10 zwischen der Laserapertur 5 und der GRIN-Linse 7. Die Haftmittel 10, 10' weisen einen an die GRIN-Linse 7 oder an das Verzögerungsplättchen 11 angepassten Brechungsindex auf. Dabei ist die GRIN-Linse 7 derart beabstandet zu dem Halbleiterlaserchip 2 angeordnet, dass sich der Mittelpunkt 13 der Laserapertur 5 in der Fokalebene 17 der GRIN-Linse 7 befindet. Der teilweise als Laserstrahl 6' rückreflektierte Laserstrahl 6 wird mittels der GRIN-Linse 7 in einem Sammelpunkt 18 fokussiert. In der dargestellten Ausführungsform fallen der Sammelpunkt 18 und der Fokuspunkt 12 der GRIN-Linse 7 mit dem Mittelpunkt 13 der Laserapertur 5 zusammen. Die Schichtdicke des Haftmittels 10 ist entsprechend gewählt. Es ist zu erkennen, dass die GRIN-Linse 7 durch den sich kontinuierlich ändernden Brechungsindex den von der Laserapertur 5 sich aufweitend ausgehenden Laserstrahl 6 beim Durchtritt durch die GRIN-Linse 7 kollimiert, so dass der Laserstrahl 6 weitgehend parallelisiert in das Verzögerungsplättchen 11 einfällt und aus diesem mit deutlich reduziertem Öffnungswinkel austritt. In diesem Ausführungsbeispiel fällt eine optische Achse 20 der GRIN-Linse 7 mit einer Mittelachse 19 der Laserapertur 5 zusammen.

Die Figur 2 zeigt eine andere Ausführungsform der erfindungsgemäßen Gasdetektions-Laserlichtquelle 1 aus Figur 1. Der einzige Unterschied zu dieser besteht darin, dass die Lichtaustrittsseite 9 der GRIN-Linse 7 sich geneigt zu der Lichteintrittsseite 8 der GRIN-Linse 7 erstreckt. Durch die geneigte Lichtaustrittsseite 9 ist das Verzögerungsplättchen 11 in einem entsprechenden Winkel gegenüber der Laserapertur 5 angeordnet. Demzufolge tritt der Laserstrahl 6 nicht mehr senkrecht zu der Abstrahlseite 4 und der Lichtaustrittsseite 9 aus dem Verzögerungsplättchen 11 aus. Der austretende Laserstrahl 6 ist gegenüber der Orthogonalen der Laserapertur 5 zu der langen Umfangsbereich 14 der GRIN-Linse 7 hin geneigt und erstreckt sich danach ebenfalls annähernd parallel. Außerdem fällt der Sammelpunkt 18 der GRIN-Linse 7 bedingt durch das geneigt zu der Abstrahlseite 4 angeordnete Verzögerungsplättchen 11 nicht mehr mit dem Mittelpunkt 13 der Laserapertur 5 und dem eigentlichen Fokuspunkt 12 der GRIN-Linse 7 zusammen. Er ist seitlich gegenüber der Laserapertur 5 derart versetz, dass der rückreflektierte Laserstrahl 6' nicht mehr auf die Laserapertur 5 fällt. Auch bei dieser Variante deckt sich die optische Achse 20 der GRIN-Linse 7 mit der Mittelachse 19 der Laserapertur 5.

Die Figur 3 zeigt eine weitere Ausführungsform der erfindungsgemäßen Gasdetektions-Laserlichtquelle 1. Diese weist die gleichen Elemente wie die in der Figur 1 dargestellte Ausführungsform auf, insbesondere ein parallel zu der Abstrahlseite 4 angeordnetes Verzögerungsplättchen 11. Der einzige Unterschied gegenüber der vorstehend beschriebenen Ausführungsform besteht darin, dass die GRIN-Linse 7 geringfügig seitlich versetzt an der Abstrahlseite 4 des Halbleiterlaserchips 2 befestigt ist, sodass die optische Achse 20 der GRIN-Linse 7 mit seitlichem Abstand zu der Mittelachse 19 der Laserapertur 5 parallel erstreckt.

Die Figur 4 zeigt eine Variante der in Figur 3 abgebildeten Gasdetektions-Laserlichtquelle 1 als neue Ausführungsform, bei der die GRIN-Linse 7 sich in der Längsrichtung nicht orthogonal zu der Abstrahlseite 4 des Halbleiterlaserchip 2 erstreckt. Die Lichteintrittsseite 8 der GRIN-Linse 7 weist dabei eine typische Neigung von 3° bis 5° gegenüber der Abstrahlseite 4 auf. Durch die Neigung der GRIN-Linse 7 gegenüber dem Halbleiterlaserchip 2 erstreckt sich der aus dem Verzögerungsplättchen 11 austretende Laserstrahl 6 in einem entsprechenden Winkel gegenüber der Abstrahlseite 4. Bei dem in Figur 4 dargestellten Ausführungsbeispiel erstreckt sich das Haftmittel nicht als planparallele Schicht zwischen der Lichteintrittsseite 8 und der Laserapertur 5, sondern weist die Form eines schräg abgeschnittenen Kreiszylinders auf. Zusätzlich ist die GRIN-Linse 7 seitlich versetzt gegenüber der Laserapertur 5 montiert, so dass der Fokuspunkt 12, der in diesem Fall auch der Sammelpunkt 18 für den rückreflektierten Laserstrahl 6' ist, sich nicht mit dem Mittelpunkt 13 der Laserapertur 5 deckt. Durch diese zusätzliche Maßnahme verfehlen rückreflektierte Anteile des Laserstrahls 6 die Laserapertur 5 vollständig. Mit der Verkippung der GRIN-Linse 7 wird erreicht, dass der Laserstrahl 6 normal zur Laserapertur 5 aus dem Verzögerungsplättchen 11 auskoppelt. Dabei ist die optische Achse 20 der GRIN-Linse 7 mit seitlichem Abstand zu der Mittelachse 19 der Laserapertur 5 angeordnet und erstreckt sich geneigt zu der zu der Mittelachse 19.

Die Figur 5 zeigt eine Weiterbildung der in der Figur 4 dargestellten Gasdetektions-Laserlichtquelle 1 mit einer Mehrkomponentenoptik. Die Mehrkomponentenoptik umfasst wie das Ausführungsbeispiel aus Figur 4 eine GRIN-Linse 7 als erste GRIN-Linse, die das Verzögerungsplättchen 11 trägt. Auf dem Verzögerungsplättchen 11 ist eine zweite GRIN-Linse 7' angeordnet, die der ersten GRIN-Linse 7 spiegelbildlich diametral gegenüberliegt. Die zweite GRIN-Linse 7' bündelt und fokussiert den von der ersten GRIN-Linse 7 kollimierten Laserstrahl 6 nach dem Durchtritt durch das Verzögerungsplättchen 11 in seiner Fokalebene 17' im Fokuspunkt 12'. Die GRIN-Linse 7' ist mit einem Haftmittel 10" an dem Verzögerungsplättchen 11 befestigt, das sich lückenlos zwischen der zweiten GRIN-Linse 7' und dem Verzögerungsplättchen 11 erstreckt. Das Haftmittel 10" ist indexangepasst und für das Infrarotlicht durchlässig. Dabei erstreckt sich eine Lichteintrittsseite 8' der GRIN-Linse 7' parallel zu der Lichtaustrittsseite 9 der ersten GRIN-Linse 7 und parallel zu dem Verzögerungsplättchen 11. Die zweite GRIN-Linse 7' trägt eine kollimierende oder fokussierende Kugellinse 15, die mit einem entsprechenden Haftmittel 10'" an der GRIN-Linse 7' an deren Lichtaustrittsseite 9' befestigt ist. Die Kugellinse 15 weist einen Abstand zu der GRIN-Linse 7' auf, bei dem sich der Fokuspunkt 16 der Kugellinse 15 in der Fokalebene 17' der GRIN-Linse 7' befindet. Dabei fällt der Fokuspunkt 12' der GRIN-Linse 7' vorzugsweise mit dem Fokuspunkt 16 der Kugellinse 15 zusammen. Durch diese spezielle Ausführungsform erstreckt sich der Laserstrahl 6 nach der Kugellinse 15 wiederum senkrecht zu der Abstrahlseite 4 mit der Laserapertur 5. Dabei verlaufen die optische Achse 20 der GRIN-Linse 7 und die Mittelachse 19 der Laserapertur 5 entsprechend dem in der Figur 4 gezeigten Ausführungsbeispiel zueinander.

Das in der Figur 6 gezeigte Ausführungsbeispiel entspricht bis auf die Art des Halbleiterlaserchips 2 der in der Figur 4 dargestellten Ausführungsform. Anstelle eines Oberflächenemitters wird jetzt ein Kantenemitter verwendet. Durch eine geeignete Verkippung der optischen Achse 20 der GRIN-Linse 7 gegenüber der optischen Achse des Laserhalbleiterchips 2, d. h. der Mittelachse 19 der Laserapertur 5 und einem geeigneten seitlichen Versatz der optischen Achse 20 der Linse 7 gegenüber der Mittelachse 19 der Laserapertur 5 wird der rückreflektierte Laserstrahl 6' nicht nur von der Laserapertur 5 ferngehalten, sondern sogar an der Abstrahlseite 4 vollkommen vorbeigelenkt.

## Patentansprüche

1. Gasdetektions-Laserlichtquelle (1), mit einem linear polarisiertes Licht emittierenden Halbleiterlaserchip (2), der eine Abstrahlseite (4) mit einer Laserapertur (5) aufweist, aus der ein sich aufweitender Laserstrahl (6) austritt, und mit einer nahe der Laserapertur (5) angeordneten kollimierenden GRIN-Linse (7), die mit einer Lichteintrittsseite (8) an der Abstrahlseite (4) mit einem Haftmittel (10) befestigt ist und dabei die Laserapertur (5) vollständig übergreift, wobei das Haftmittel (10) lichtdurchlässig ist und sich zumindest lückenlos über die Laserapertur (5) erstreckt, **dadurch gekennzeichnet, dass** auf der GRIN-Linse (7) ein Verzögerungsplättchen (11) an einer Lichtaustrittsseite (9) angeordnet ist, wobei das Verzögerungsplättchen (11) mit einem Haftmittel (10') an der GRIN-Linse (7) fixiert ist, das die Lichtaustrittsseite (9) soweit abdeckt, dass der Lichtstrahl in dem Haftmittel geführt ist.

2. Gasdetektions-Laserlichtquelle nach Anspruch 1, **dadurch gekennzeichnet, dass** die GRIN-Linse (7) so positioniert ist, dass die Laserapertur (5) in der Fokalebene (17) der GRIN-Linse (7) liegt.

3. Gasdetektions-Laserlichtquelle nach Anspruch 1 oder 2, **dadurch gekennzeichnet, dass** das Verzögerungsplättchen (11) derart angeordnet ist, dass sich dessen optische Achse in einem 45°-Winkel zu dem elektromagnetischen Feld des in das Verzögerungsplättchen (11) einfallenden Laserstrahls (6) befindet.

4. Gasdetektions-Laserlichtquelle nach einem der vorstehenden Ansprüche, **dadurch gekennzeichnet, dass** eine optische Achse (20) der GRIN-Linse seitlich versetzt gegenüber einer Mittelachse (19) der Laserapertur (5) angeordnet ist.

5. Gasdetektions-Laserlichtquelle nach einem der vorstehenden Ansprüche, **dadurch gekennzeichnet, dass** die GRIN-Linse (7) eine parallel zu der Lichteintrittsseite (8) verlaufende Lichtaustrittsseite (9) aufweist und seitlich verkippt an der Abstrahlseite (4) befestigt ist.

6. Gasdetektions-Laserlichtquelle nach einem der vorstehenden Ansprüche, **dadurch gekennzeichnet, dass** die Abstrahlseite (4) eine um die Laserapertur (5) angeordnete Zone mit verminderter Reflexionsfähigkeit aufweist.

7. Gasdetektions-Laserlichtquelle nach Anspruch 6, **dadurch gekennzeichnet, dass** die Zone ein laserlichtabsorbierendes Material aufweist.

8. Gasdetektions-Laserlichtquelle nach einem der vorstehenden Ansprüche, **dadurch gekennzeichnet, dass** auf dem Verzögerungsplättchen (11) eine zweite GRIN-Linse (7') angeordnet ist, die der ersten, der Laserapertur (5) zugeordneten GRIN-Linse (7) diametral oder seitlich versetzt spiegelbildlich gegenüberliegt und mit einem Haftmittel (10") an dem Verzögerungsplättchen (11) befestigt ist, das sich lückenlos zwischen der zweiten GRIN-Linse (7') und dem Verzögerungsplättchen (11) erstreckt und das für Laserlicht durchlässig ist.

9. Gasdetektions-Laserlichtquelle nach Anspruch 8, **dadurch gekennzeichnet, dass** auf der zweiten GRIN-Linse (7') eine kollimierende oder fokussierende Linse (15) angeordnet ist, die mit Haftmittel (10'") an der GRIN-Linse (7') befestigt ist, das die Lichtaustrittsseite (9') vollständig bedeckt und für Laserlicht durchlässig ist, wobei der Abstand zwischen der zweiten GRIN-Linse (7') und der kollimierenden oder fokussierenden Linse (15) derart gewählt ist, dass der Fokuspunkt (16) der Linse (15) in der Fokalebene (17') der zweiten GRIN Linse (7') liegt.

10. Gasdetektions-Laserlichtquelle nach einem der vorstehenden Ansprüche, **dadurch gekennzeichnet, dass** die Dicke und/oder die Orientierung des Verzögerungsplättchens (11) derart gewählt ist, dass eine Drehung des elektromagnetischen Feldes bei einem zweimaligen Durchgang des Laserstrahls (6) um 90°erfolgt.

11. Gasdetektions-Laserlichtquelle nach einem der vorstehenden Ansprüche, **dadurch gekennzeichnet, dass** das Haftmittel (10, 10', 10", 10'") einen der jeweiligen GRIN-Linse (7, 7') und/oder dem Verzögerungsplättchen (11) zumindest annähernd gleichen Brechungsindex aufweist.

12. Gasdetektions-Laserlichtquelle nach einem der vorstehenden Ansprüche, **dadurch gekennzeichnet, dass** der von der Laserapertur (5) emittierte Laserstrahl (6) nach dem erstmaligen Durchtritt durch das Verzögerungsplättchen (11) zirkular polarisiert ist.

13. Gasdetektions-Laserlichtquelle nach einem der vorstehenden Ansprüche, **dadurch gekennzeichnet, dass** das Verzögerungsplättchen (11) ein Lambda-Viertel-Plättchen, vorzugsweise ein Quarz-Plättchen ist.
